# EUROPEAN PATENT SPECIFICATION

(11) **EP 4 063 317 B1**
(45) Date of publication and mention of the grant of the patent: **28.10.2026**
(21) Application number: 20910700.2
(22) Date of filing: 23.12.2020
(51) Int. Cl.: B81B 3/00, G02B 26/08, H02N 1/00

(54) **MICRO-ELECTRO-MECHANICAL SYSTEM AND PREPARATION METHOD THEREFOR**
MIKROELEKTROMECHANISCHES SYSTEM UND VERFAHREN ZU DESSEN HERSTELLUNG
MICROSYSTÈME ÉLECTROMÉCANIQUE ET PROCÉDÉ POUR SA PRÉPARATION

(30) Priority: 31.12.2019 CN 201911408207
(43) Date of publication of application: 28.09.2022
(73) Proprietor: Huawei Technologies Co., Ltd., Shenzhen, Guangdong 518129 (CN)
(72) Inventor: SUN, Fengpei, Shenzhen, Guangdong 518129 (CN); FENG, Zhihong, Shenzhen, Guangdong 518129 (CN); XU, Jinghui, Shenzhen, Guangdong 518129 (CN)
(74) Representative: Gill Jennings & Every LLP
(86) International application number: PCT/CN2020/138746
(87) International publication number: WO 2021/136042

(56) References cited:
- CN-A- 101 907 769
- CN-A- 102 298 207
- CN-A- 102 298 207
- CN-A- 105 353 506
- CN-A- 107 667 067
- CN-A- 110 568 611
- CN-A- 110 568 611
- CN-A- 111 204 701
- CN-U- 210 639 349
- DE-B3- 102005 063 640
- US-A- 5 959 760
- US-A1- 2006 268 383
- US-A1- 2015 234 176
- US-A1- 2015 234 176
- US-B2- 8 691 099

## Description

### TECHNICAL FIELD

The present invention relates to the micro-electro-mechanical systems (MEMS) field, and in particular, to an MEMS apparatus and a preparation method thereof.

### BACKGROUND

A micro-electro-mechanical systems MEMS device is widely applied to the optical communications field, the consumer electronics field, and the like. A principle thereof is that an electrostatic force and electrostatic torque are generated by using an electric potential difference loaded on a drive structure of the MEMS device, to drive a movable component in the MEMS device to rotate or translate. The drive structure of the MEMS device includes a plate structure, a comb finger structure, and the like.

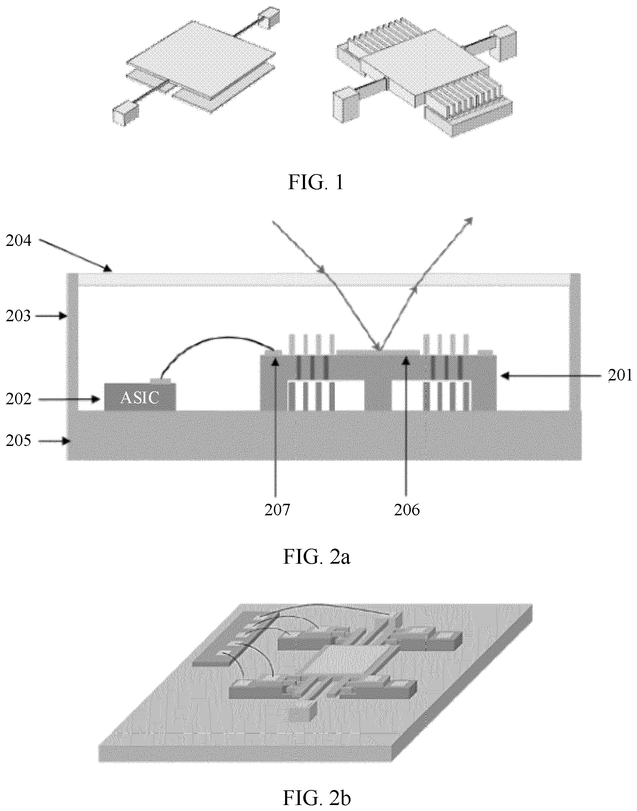

As shown on a left side of FIG. 1, a movable platform of an MEMS device of the plate structure is connected to fastening anchors by using a support beam between two sides, and two fixed electrodes are located under the movable platform to form a plate capacitor with the movable platform. The movable platform is an upper electrode of the plate capacitor, and the fixed electrodes are lower electrodes. The movable platform is grounded by using the support beam and the anchors, and a constant or periodically-changed electrostatic bias voltage is applied to the fixed electrode. An electric potential difference between the upper and lower electrodes generates an electrostatic force and electrostatic torque, to drive the movable platform to rotate around the support beam. As shown on a right side of FIG. 1, two sides of a movable platform of an MEMS device of the comb finger structure are connected to movable comb fingers, respectively corresponding to two groups of lower fixed comb fingers. The movable comb fingers are grounded, and a constant or periodically-changed electrostatic bias voltage is applied to the fixed comb fingers. An electric potential difference between the movable comb fingers and the fixed comb fingers generates electrostatic torque, to drive the movable platform to rotate around a support beam. US 5 959 760 A discloses a light beam scanner comprising a supporting substrate, fixed electrodes of a first set provided on said supporting substrate to oppose to each other, a mirror provided between said fixed electrodes, having torsion bars physically connected to said supporting substrate and a mirror electrode section in end portions of said mirror opposing to said fixed electrodes at least, wherein said mirror rotatably vibrates between an upper position of said one fixed electrode and a lower position thereof by torsion force of said torsion bars and electrostatic force due to a voltage using said torsion bars as a rotation axis, when said voltage is applied between one of said fixed electrodes and said electrode section.

### SUMMARY

The present invention is set out in the appended set of claims.

According to a first aspect, the present invention provides a micro-electro-mechanical systems MEMS apparatus, including first fixed comb fingers, second fixed comb fingers, a support beam, a movable platform, and movable comb fingers. The first fixed comb fingers and the second fixed comb fingers are fastened to a substrate, and the first fixed comb fingers are electrically isolated from the second fixed comb fingers. Two ends of the support beam are fastened to the substrate, and the movable platform is connected to the support beam. The movable comb fingers are connected to the movable platform, and form a three-layer comb finger structure with the first fixed comb fingers and the second fixed comb fingers. The first fixed comb fingers are arranged in a first layer, the second fixed comb fingers are arranged in a second layer, and the movable comb fingers are arranged in a third layer between the first and second layers. The three-layer comb finger structure improves drive efficiency of the MEMS apparatus, and reduces a drive voltage required at specific torque.

In a possible design, the MEMS apparatus includes two three-layer comb finger structures, respectively located on a left side and a right side of the support beam. Therefore, a drive capability is further improved.

In another possible design, the first fixed comb fingers are configured to apply a first electric potential difference between the first fixed comb fingers and the movable comb fingers, and the second fixed comb fingers are configured to apply a second electric potential difference between the second fixed comb fingers and the movable comb fingers. Therefore, a drive capability is further improved.

In another possible design, a metal reflection layer or a dielectric reflection layer is plated on the movable platform. Therefore, the MEMS apparatus can be more widely applied to in the optical communications system field, the consumer electronics field, and the like.

In another possible design, a shape of the movable platform is a rectangle, a polygon, a circle, or an oval. An application scope of the MEMS apparatus is expanded due to different platform shapes.

In another possible design, the first fixed comb fingers are configured to apply an electric potential difference between the first fixed comb fingers and the movable comb fingers, and the second fixed comb fingers are configured to measure a rotation angle of the movable platform by using a capacitance between the second fixed comb fingers and the movable comb fingers. Therefore, an application scope of the MEMS apparatus is further expanded.

According to the invention, the support beam is electrically isolated from the substrate. Therefore, net charge accumulation of the MEMS apparatus is avoided, and long-term stability of the MEMS apparatus is improved.

According to the invention, the first fixed comb fingers are electrically isolated from the second fixed comb fingers by using a first insulation layer, the support beam is electrically isolated from the substrate by using a second insulation layer, and the first insulation layer and the second insulation layer are located on a same plane. This helps reduce a volume of the MEMS apparatus, and reduce preparation costs.

In another possible design, the movable comb fingers are connected to a side that is of the movable platform and that is perpendicular to the support beam, and the three-layer structure abuts against the support beam. This structure helps reduce a size of the MEMS apparatus, and facilitates application to a micromirror array.

In another possible design, the MEMS apparatus includes two three-layer comb finger structures, located on a same side of the support beam, and the two three-layer comb finger structures are separately configured to control the movable platform. This helps improve drive flexibility of the movable platform.

In another possible design, one of the two three-layer comb finger structures is configured to apply an electric potential difference to drive the movable platform, and the other three-layer comb finger structure is configured to measure a rotation angle of the movable platform. This helps improve use flexibility the MEMS apparatus.

In another possible design, a two-dimensional MEMS apparatus is provided, including two MEMS apparatuses as described above: a first MEMS apparatus and a second MEMS apparatus. A movable platform of the first MEMS apparatus is used as a substrate for fastening the second MEMS apparatus. A support beam of the first MEMS apparatus and a support beam of the second MEMS apparatus are perpendicular to each other. Therefore, two-dimensional rotation of the movable platform is implemented, and an application scope of the MEMS apparatus is further expanded.

In another possible design, an MEMS apparatus array is provided, including a plurality of MEMS apparatuses described above. The plurality of MEMS apparatuses are one-dimensionally distributed or two-dimensionally distributed.

In another possible design, the MEMS apparatus further includes the substrate, a tube housing, a light window, and a control circuit. The substrate is configured to: fasten the first fixed comb fingers and the second fixed comb fingers, and fasten the two ends of the support beam. The tube housing is installed on the substrate, and is configured to protect the MEMS apparatus. The light window is installed on the top of the tube housing, and is configured for light incidence and emergence. The control circuit is configured to control rotation of the movable platform. This complete product helps ensure long-time use of the MEMS apparatus.

According to a second aspect, an embodiment of the present invention provides a preparation method of an MEMS apparatus as described above, including: forming first fixed comb fingers on a first wafer through photoetching; forming movable comb fingers, a movable platform, and a support beam on a double-layer second wafer through photoetching; bonding the first wafer to the double-layer second wafer; forming second fixed comb fingers on the bonded wafer through photoetching; and releasing the movable platform and the movable comb fingers. In this method, the foregoing MEMS apparatus of the three-layer comb finger structure is implemented by using one single-layer wafer and one double-layer wafer.

According to a third aspect, an embodiment of the present invention provides another preparation method of an MEMS apparatus, including: forming first fixed comb fingers on a first wafer through photoetching; bonding a second wafer to the first wafer; forming, through photoetching, movable comb fingers, a movable platform, and a support beam on the wafer obtained after the two wafers are bonded; bonding a third wafer to the wafer obtained after the two wafers are bonded; forming, through photoetching, second fixed comb fingers on the wafer obtained after the three wafers are bonded; and releasing the movable platform and the movable comb fingers. In this method, the foregoing MEMS apparatus of the three-layer comb finger structure is implemented by using three single-layer wafers.

According to a fourth aspect, an embodiment not forming part of the claimed invention provides a use method of an MEMS apparatus, including: applying an electric potential difference between first fixed comb fingers and movable comb fingers of the MEMS apparatus to rotate a movable platform; and measuring a capacitance between second fixed comb fingers and the movable comb fingers of the MEMS apparatus to monitor a rotation angle of the movable platform. In this way, after a change in performance of the MEMS apparatus is monitored, measures may be further taken to compensate for the change in the performance, so that the MEMS apparatus is also applicable to a scenario in which a working environment greatly changes and a scenario in which working is continuous without stopping, thereby expanding a use scope of the MEMS apparatus.

In the foregoing technical solutions provided in the embodiments of the present invention, drive efficiency of the MEMS apparatus is improved, a drive voltage is reduced, a problem of net charge accumulation of the MEMS apparatus is alleviated, and long-term stability of the MEMS apparatus is improved. In addition, because the drive efficiency is improved, an occupation area of a drive structure in the MEMS apparatus accordingly decreases, thereby improving an effective duty cycle of the MEMS apparatus, and expanding an application scope of the MEMS apparatus.

### BRIEF DESCRIPTION OF DRAWINGS

FIG. 1 is a schematic diagram of MEMS apparatuses of a plate structure and a comb finger structure in the conventional technology;
FIG. 2a is a schematic diagram of a cross section of an MEMS apparatus;
FIG. 2b is a schematic diagram of an MEMS apparatus at 45°;
FIG. 3a is a schematic diagram of another MEMS apparatus at 45°;
FIG. 3b is a schematic diagram of a cross section of another MEMS apparatus;
FIG. 3c is a schematic diagram of a cross section of still another MEMS apparatus;
FIG. 4a is a schematic diagram of a rotated state of an MEMS apparatus;
FIG. 4b is a schematic simulation diagram of a relationship between a capacitance of a feedback structure and a rotation angle of a movable platform;
FIG. 5a is a schematic diagram of still another MEMS apparatus at 45°;
FIG. 5b is a schematic diagram of a cross section of still another MEMS apparatus;
FIG. 6 is a schematic diagram of a one-dimensionally arranged MEMS apparatus array;
FIG. 7 is a schematic diagram of still other MEMS apparatuses;
FIG. 8 is a schematic diagram of still other MEMS apparatuses;
FIG. 9 is a schematic diagram of still other MEMS apparatuses;
FIG. 10 is a schematic diagram of an MEMS apparatus having a plurality of three-layer comb finger structure on a same side;
FIG. 11 is a schematic diagram of a two-dimensional MEMS apparatus;
FIG. 12 is a schematic diagram of a preparation method of an MEMS apparatus; and
FIG. 13 is a schematic diagram of another preparation method of an MEMS apparatus. None of the figures shows a MEMS apparatus that exhibits all features of the claimed invention. Rather, the figures illustrate particular features of the invention which as set out in the claims.

### DESCRIPTION OF EMBODIMENTS

To make objectives, technical solutions, and advantages of the present invention clearer, the following further describes implementations of the present invention in detail with reference to accompanying drawings.

Electrostatic torque generated by a current drive structure is relatively limited. Technology development, device miniaturization, and the like all require an MEMS apparatus to be able to generate larger drive torque, reduce a bias voltage, and reduce an MEMS chip area.

An MEMS apparatus provided in the embodiments of the present invention may be an MEMS chip and may be used as an MEMS micromirror or micromirror array. The MEMS apparatus is widely applied to the optical communications field. For example, the MEMS apparatus generates a plurality of output optical signals through crossreflection of a plurality of input optical signals, to implement optical cross-connect. The MEMS apparatus is further widely applied to the consumer field. For example, the MEMS device adjusts an optical path to implement human eye movement tracking in the augmented reality (AR) field.

FIG. 2a and FIG. 2b show an MEMS apparatus. FIG. 2a is a diagram of a cross section of the MEMS apparatus. FIG. 2b is a schematic diagram of the MEMS apparatus at 45°. A light window and a sidewall are removed in FIG. 2b.

An MEMS chip 201 and a control ASIC Application-Specific Integrated Circuit (ASIC) 202 are packaged in a tube housing 203, and the top of the tube housing is a transparent light window 204, so that light is allowed to be incident and emergent. The MEMS apparatus is fastened to a substrate 205, and the substrate may be a ceramic substrate. A reflection layer 206 is plated on a movable platform of the MEMS apparatus, and is configured to reflect light incident from the light window. The control ASIC is connected to an electrode 207 of comb fingers of the MEMS apparatus by using a lead, and is configured to control the movable platform, for example, control rotation or translation of the movable platform by loading an electrostatic bias onto a three-layer comb finger structure.

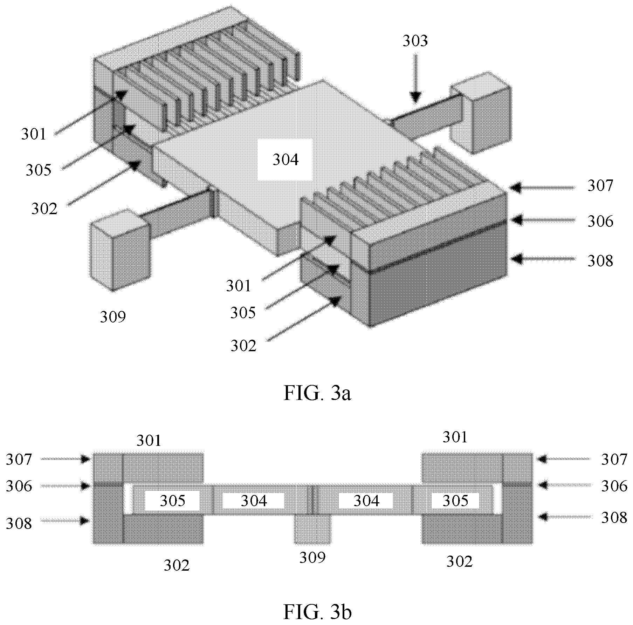

FIG. 3a and FIG. 3b are schematic diagrams of an MEMS apparatus of a three-layer comb finger structure and show a specific embodiment of the foregoing MEMS chip 201. FIG. 3a is a schematic diagram of the MEMS apparatus at 45°. FIG. 3b is a diagram of a cross section of the MEMS apparatus. The MEMS apparatus includes upper-layer fixed comb fingers 301, lower-layer fixed comb fingers 302, a support beam 303, a movable platform 304, and movable comb fingers 305. The movable comb fingers form one three-layer comb finger structure with the upper-layer fixed comb fingers and the lower-layer fixed comb fingers. The MEMS apparatus may include one or more three-layer comb finger structures. The MEMS apparatus in FIG. 3a and FIG. 3b includes two three-layer comb finger structures, located on left and right sides of the support beam.

Lower-layer fixed comb fingers and upper-layer fixed comb fingers on each of the left and right sides are fastened to a substrate, and the substrate is not drawn in FIG. 3a and FIG. 3b. There is an insulation layer 306 between the upper-layer and lower-layer fixed comb fingers, to implement electrical isolation, so that voltages on the upper-layer and lower-layer fixed comb fingers can be separately controlled to form an electric potential difference with the movable comb fingers. The upper-layer and lower-layer fixed comb fingers are connected to respective electrodes, including an electrode 307 of the upper-layer fixed comb fingers and an electrode 308 of the lower-layer fixed comb fingers. A material of the insulation layer may be silicon dioxide SiO2, silicon nitride SixNy, or the like.

Two ends of the support beam are also fastened to the substrate, and fastening parts on two sides may be referred to as anchors 309. The movable platform is connected to the support beam. The movable comb fingers on the left and right sides are connected to the movable platform, and form two three-layer comb finger structures on the left and right sides with the upper-layer fixed comb fingers and the lower-layer fixed comb fingers. An upper part and a lower part of the movable comb fingers respectively correspond to the upper-layer fixed comb fingers and the lower-layer fixed comb fingers, and the movable comb fingers are separately staggered from the upper-layer and lower-layer fixed comb fingers in a horizontal direction, to avoid collision with the fixed comb fingers during rotation around the support beam. The movable comb fingers can be grounded by using the movable platform, the support beam, and the anchors.

The substrate may be a plate, or may be a hollow frame or another fastener that can fasten the upper-layer and lower-layer fixed comb fingers and the two ends of the support beam.

The movable platform, the support beam, the upper-layer fixed comb fingers, the lower-layer fixed comb fingers, and the movable comb fingers all may be made of doped monocrystalline silicon or polycrystalline silicon. A metal reflection layer (such as aluminum or gold) or a dielectric reflection layer may be plated on the movable platform.

The movable comb fingers are connected to the support beam between the two sides by using the movable platform, and the movable comb fingers can rotate around the support beam. When the movable platform needs to be driven to rotate, electrostatic bias voltages may be respectively applied to left-side upper-layer fixed comb fingers and right-side lower-layer fixed comb fingers. Because the movable comb fingers are grounded, an electric potential difference between the left-side upper-layer fixed comb fingers and movable comb fingers generates electrostatic torque M1, and an electric potential difference between the right-side lower-layer fixed comb fingers and movable comb fingers generates electrostatic torque M2. M1 and M2 are in a same direction, so that torque for driving the movable platform to clockwise rotate around the support beam is M1+M2. Likewise, if electrostatic bias voltages are respectively applied to right-side upper-layer fixed comb fingers and left-side lower-layer fixed comb fingers, the movable platform can be driven to counterclockwise rotate around the support beam.

The drive torque is increased due to the three-layer comb finger structure, thereby improving drive efficiency of the MEMS apparatus. Because the drive efficiency is improved, an occupation area of a drive structure in the MEMS apparatus accordingly decreases, thereby improving an effective duty cycle of the MEMS apparatus. In addition, a drive voltage is also reduced due to the three-layer comb finger structure, thereby alleviating a problem of net charge accumulation of the MEMS apparatus, and improving long-term stability of the MEMS apparatus. An application scope of the MEMS apparatus is expanded due to these effects.

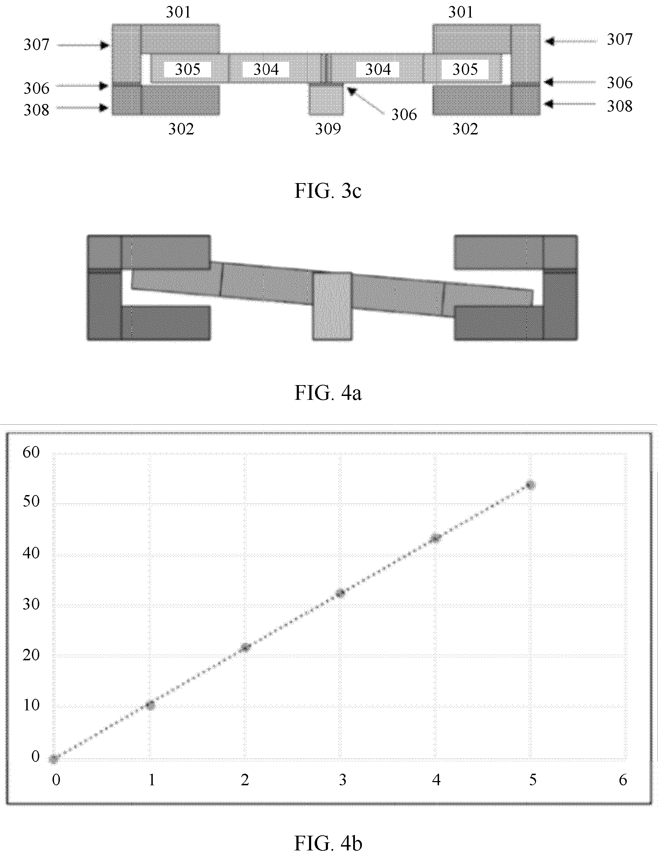

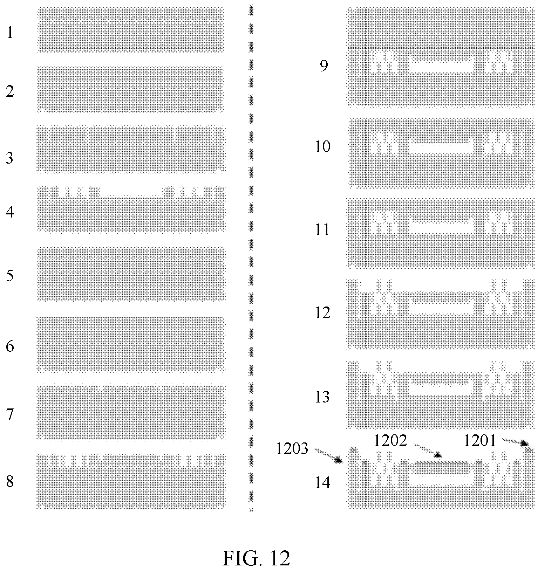

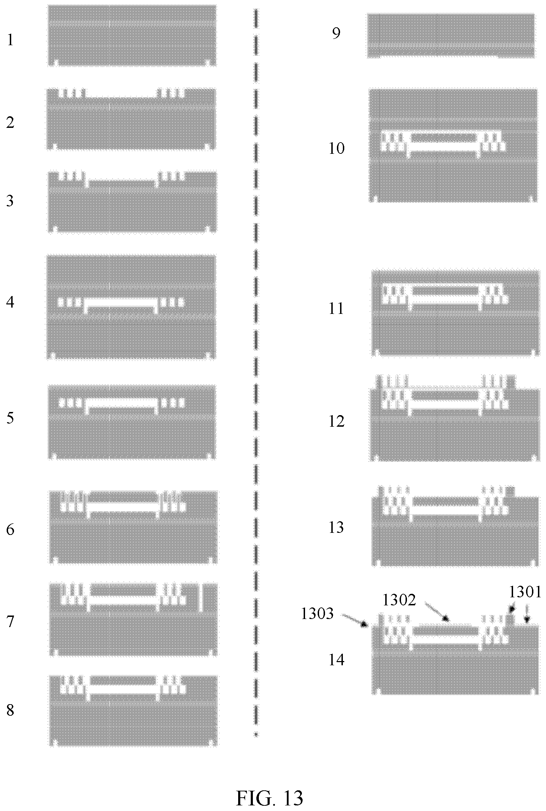

An insulation layer may also be disposed between the anchor and the support beam. During electrostatic driving, the movable comb fingers and the movable platform can be ungrounded, and an electrostatic bias is separately applied, to flexibly control an electric potential difference between the movable comb fingers and the upper-layer or lower-layer fixed comb fingers. Therefore, drive control flexibility is improved. Further, the insulation layer between the anchor and the support beam may be located on a same plane as the insulation layer between the upper-layer and lower-layer fixed comb fingers, as shown in FIG. 3c. The insulation layers are located on the same plane, thereby facilitating preparation of the MEMS apparatus. For details, refer to steps 13 in the following preparation method embodiments shown in FIG. 12 and FIG. 13.

In addition to being configured to drive the movable platform to rotate, the MEMS apparatus may be further configured to monitor a rotation angle of the movable platform. For example, FIG. 4a is a schematic diagram in which a movable platform of an MEMS apparatus rotates when being driven by a drive structure. Right-side upper-layer fixed comb fingers and movable comb fingers form a drive structure, and right-side lower-layer fixed comb fingers and the movable comb fingers form a feedback structure. When a bias voltage is applied to the right-side upper-layer fixed comb fingers, torque generated by an electric potential difference with the movable comb fingers may drive the movable platform to rotate. In addition, a rotation angle A of the movable platform may be monitored by measuring a capacitance C of the feedback structure. FIG. 4b is a schematic simulation diagram of a relationship between the capacitance C of the feedback structure and the rotation angle A of the movable platform. A horizontal coordinate represents a rotation angle in a unit of degree (°), and a vertical coordinate represents a capacitance change in a unit of femtofarad (fF).

Likewise, alternatively, the right-side lower-layer fixed comb fingers and the movable comb fingers may form a drive structure, and the upper-layer fixed comb fingers and the movable comb fingers may form a feedback structure. When the movable platform is driven to rotate, a rotation angle of the movable platform is monitored by measuring a capacitance of the feedback structure.

Usually, performance of the MEMS apparatus changes with change of an environmental factor such as a temperature, or with increase of working time. For example, a rotation angle of the movable platform may be different due to a same electric potential difference at different temperatures or during different working duration. After a change in the performance of the MEMS apparatus is monitored, measures may be taken to compensate for the change in the performance, for example, a drive electric potential difference is further adjusted, so that the MEMS apparatus is also applicable to a scenario in which a working environment greatly changes and a scenario in which working is continuous without stopping, thereby expanding a use scenario and a use scope of the MEMS apparatus.

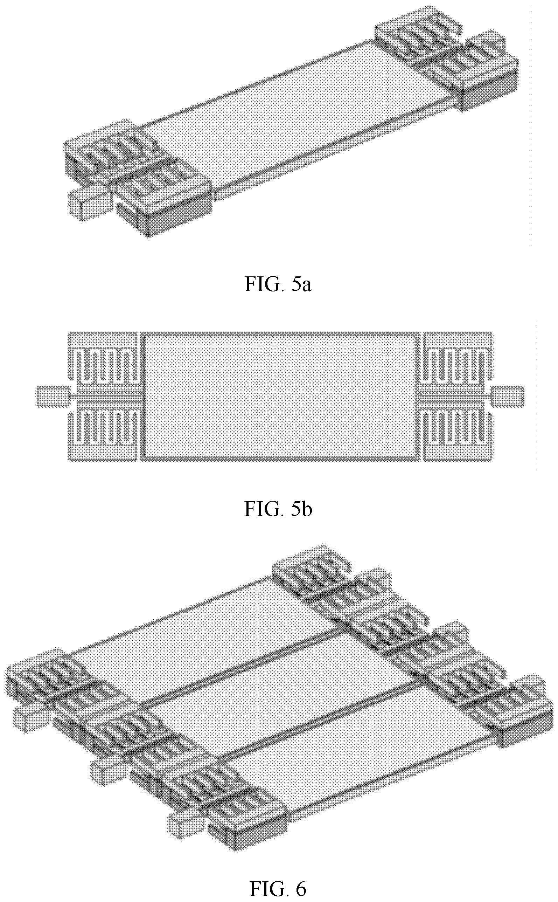

FIG. 5a and FIG. 5b disclose a structure of another MEMS apparatus. FIG. 5a is a schematic diagram of the MEMS apparatus at 45°. FIG. 5b is a diagram of a cross section of the MEMS apparatus. A movable platform is connected to fastening anchors by using a support beam, and can rotate around the support beam. Three-layer comb finger structures included in the MEMS apparatus are located on two sides of the support beam, and are close to sides that are of the movable platform and that are perpendicular to the support beam, and movable comb fingers are connected to the sides that are of the movable platform and that are perpendicular to the support beam. This structure helps reduce a size of the MEMS apparatus. A relatively small spacing may be implemented when a plurality of MEMS apparatuses form an array.

FIG. 6 is a one-dimensionally arranged MEMS apparatus array. Alternatively, the array may be two-dimensionally arranged, for example, an M*N array, arranged in M rows, where each row has N (M and N are integers) MEMS apparatuses. The MEMS apparatus array can accurately control reflection directions of different beams, so that the MEMS apparatus array can be applied to modules such as an optical cross-connect OXC module and a wavelength selective switching WSS module in the optical communications field, or can be applied to devices such as a micro projector and a laser TV in the consumer field.

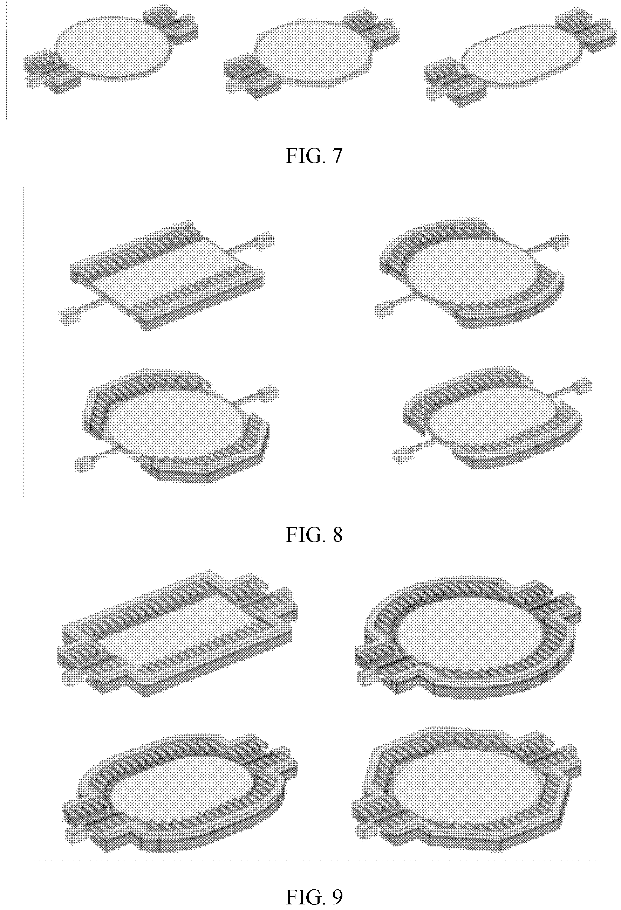

In addition to a rectangular MEMS apparatus shown in FIG. 5, as shown in FIG. 7, a shape of the movable platform may include but is not limited to a polygon, a circle, or an oval. A drive method of the MEMS apparatus is the same as that described above. In this way, an application scope of the MEMS apparatus is also expanded.

As shown in FIG. 8, alternatively, three-layer comb finger structures of the MEMS apparatus may be located on two sides of a movable platform, and distributed in an axial direction parallel to a support beam. An advantage is that electrostatic torque for driving comb fingers is greater, so that the movable platform can be driven to rotate at a larger angle.

Further, three-layer comb finger structures may be distributed on two sides of each of a support beam and a movable platform, as shown in FIG. 9. An advantage is that comb fingers are more and an electrostatic drive force or electrostatic drive torque is stronger, so that a rotation angle or displacement of the movable platform is larger. A drive method of the movable platform is the same as that described above.

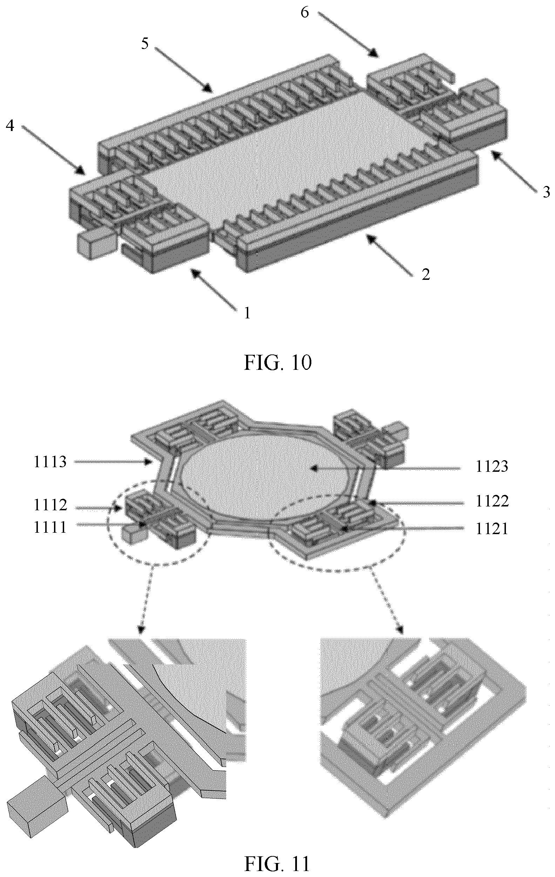

Alternatively, the MEMS apparatus may have at least two three-layer comb finger structures on a same side. FIG. 10 shows another MEMS apparatus. Two sides of a support beam each have three three-layer comb finger structures. A right side of the support beam includes three-layer comb finger structures 1, 2, and 3. A left side of the support beam includes three-layer comb finger structures 4, 5, and 6. The six comb finger structures are controlled independently of each other. Each three-layer comb finger structure may independently drive a movable platform to rotate, or may be flexibly combined to drive the movable platform to rotate.

Likewise, one group of fixed comb fingers and movable comb fingers of each three-layer comb finger structure may be used as a feedback structure, and a rotation angle of the movable platform is fed back by using a capacitance of the feedback structure. Specific drive and feedback methods are the same as those described above. Further, a three-layer comb finger structure with a relatively large quantity of comb fingers is used as a drive comb finger structure, and a three-layer comb finger structure with a relatively small quantity of comb fingers is used as a feedback comb finger structure. In this way, measurement accuracy is higher. Specifically, as shown in FIG. 10, a quantity of comb fingers in each of the second and the fifth three-layer comb finger structures is greater than those in the other four three-layer comb finger structures. In this way, the second and the fifth three-layer comb finger structures each may be used as a drive structure separately or together with another three-layer comb finger structure, and the other three-layer comb finger structures that are not used as drive structures may be used as feedback structures.

Likewise, for this MEMS apparatus including a plurality of comb finger structures on a same side, a shape of a movable platform may include but is not limited to a polygon, a circle, or an oval. A plurality of three-layer comb finger structures on a same side of a support beam are independent of each other, thereby improving application flexibility, and improving control accuracy of the MEMS apparatus.

As shown in FIG. 11, an embodiment further provides a two-dimensional MEMS apparatus, to implement two-dimensional rotation of a movable platform. This two-dimensional MEMS apparatus is equivalent to including two MEMS apparatuses, referred to as a first MEMS apparatus and a second MEMS apparatus. The first MEMS apparatus includes a first support beam 1111, first three-layer comb finger structures 1112, and a movable frame 1113. The second MEMS apparatus includes a second support beam 1121, second three-layer comb finger structures 1122, and a movable platform 1123. The active frame 1113 is used as a movable platform of the first MEMS apparatus, and is also used as a substrate for fastening the second MEMS apparatus.

The movable frame 1113 is connected to the first support beam 1111, and two sides of the first support beam are fastened to a substrate of the entire two-dimensional MEMS apparatus by using anchors (the substrate is not shown in the figure). The three-layer comb finger structures 1112 of the first MEMS apparatus are located on two sides of the first support beam. The movable platform 1123 in the figure, namely, a circular mirror, is a movable platform of the second MEMS apparatus and is also a movable platform of the entire two-dimensional MEMS apparatus; and is fastened to the active frame 1113 by using the second support beam 1121, where fastening points are equivalent to anchors. Upper-layer and lower-layer fixed comb fingers of the three-layer comb finger structures 1122 of the second MEMS apparatus are also fastened to the movable frame 1113, and the second three-layer comb finger structures 1122 are located on two sides of the second support beam 1121. The first support beam and the second support beam are perpendicular to each other. FIG. 11 further includes partial enlarged diagrams of the two MEMS apparatuses.

The three-layer comb finger structures of the first MEMS apparatus and the three-layer comb finger structures of the second MEMS apparatus are controlled, so that the movable platform can rotate around not only the first support beam but also the second support beam, thereby implementing two-dimensional rotation of the movable platform. A method for controlling the comb finger structure is the same as that described above. Likewise, a shape of the movable platform of the two-dimensional MEMS apparatus may include but is not limited to a rectangle, a polygon, a circle, an oval, or the like. The two-dimensional rotation of the movable platform greatly expands an application scope of the MEMS apparatus.

A plurality of two-dimensional MEMS apparatuses may alternatively form a one-dimensional or two-dimensional MEMS apparatus array. The MEMS apparatus array can accurately control reflection directions of different beams, so that the MEMS apparatus array can be applied to modules such as an optical cross-connect OXC module and a wavelength selective switching WSS module in the optical communications field, or can be applied to devices such as a micro projector and a laser TV in the consumer field.

The present invention further provides a preparation method of an MEMS apparatus as specified in the claims. The MEMS apparatus is prepared through one-time wafer bonding by using one single-layer wafer and one double-layer wafer. The preparation method specifically includes: forming lower-layer fixed comb fingers on a wafer through photoetching; forming movable comb fingers, a movable platform, and a support beam on another double-layer wafer through photoetching; bonding the two wafers; then forming upper-layer fixed comb fingers on the bonded wafer through photoetching; and releasing the movable platform and the movable comb fingers.

A more specific embodiment for preparing an MEMS apparatus is shown in FIG. 12, and includes the following 14 steps: 1. Select a heavily-doped silicon-on-insulator (SOI) first wafer as a substrate for preparing lower-layer fixed comb fingers. 2. Make double-sided photoetching alignment marks at a substrate layer of the first wafer. 3. Form electrical isolation grooves of the lower-layer fixed comb fingers on a device layer of the first wafer through etching. 4. Form the lower-layer fixed comb fingers and a movable platform back cavity structure through photoetching. 5. Select another double-layer heavily-doped SOI second wafer as a substrate for making a movable platform, movable comb fingers, and a lead. 6. Make double-sided photoetching alignment marks at a substrate layer of the second wafer. 7. Form a support beam region through photoetching. 8. Form the movable comb fingers and electrical isolation grooves of the lower-layer fixed comb fingers through photoetching. 9. Form one wafer through Si-Si bonding by using the two SOI wafers. 10. Remove an uppermost Si layer of the wafer through etching. 11. Remove an uppermost SiO2 layer of the wafer through etching. 12. Form upper-layer fixed comb fingers through photoetching. 13. Etch an SiO2 layer through vapor-phase HF etching, to release the movable platform and the movable comb fingers, where a remaining silicon dioxide (SiO2) layer in the double-layer second wafer forms an insulation layer 1203 between the comb fingers. In the three-layer comb finger structure the first fixed comb fingers and second fixed comb fingers are electrically isolated from each other by using the insulation layer 1203, and a support beam and a substrate are also electrically isolated from each other by using the insulation layer, so that one insulation layer implements two types of electrical isolation. 14. Prepare metal electrodes 1201 and a mirror reflection layer 1202.

The present invention further provides another preparation method of an MEMS apparatus as specified in the claims. The MEMS apparatus is prepared through two-time wafer bonding by using three single-layer wafers. The preparation method specifically includes: forming lower-layer fixed comb fingers on a first wafer through photoetching; bonding a second wafer to the first wafer; forming movable comb fingers, a movable platform, and a support beam on the bonded wafer through photoetching; bonding a third wafer to the bonded wafer; forming**,** through photoetching, upper-layer fixed comb fingers on the wafer obtained after the three wafers are bonded; and releasing the movable platform and the movable comb fingers. A two-time bonding process is more complicated.

A more specific embodiment for preparing an MEMS apparatus is shown in FIG. 13, and includes the following 14 steps: 1. Make double-sided photoetching alignment marks at a substrate layer of a doped SOI first wafer. 2. Form lower-layer fixed comb fingers and a movable platform back cavity through photoetching. 3. Form electrical isolation grooves of the lower-layer fixed comb fingers through etching. 4. Form one wafer through Si-Si bonding by using the first wafer and a doped SOI second wafer. 5. Remove an uppermost Si layer of the wafer through etching. 6. Form movable comb fingers through photoetching. 7. Reduce heights of the lower-layer fixed comb fingers through etching. 8. Remove a hard mask on a surface of a device layer through etching. 9. Prepare a cap (cap) wafer for second-time wafer bonding by using a third wafer. 10. Perform Si-SiO2 bonding on the third wafer and the foregoing bonded wafer to complete the second-time wafer bonding. 11. Remove an uppermost Si layer of a wafer through etching. 12. Form upper-layer fixed comb fingers through etching. 13. Remove SiO2 on the upper-layer fixed comb fingers through vapor-phase HF etching, to release the movable platform and the movable comb fingers, where a remaining SiO2 layer in the second wafer forms an insulation layer 1303 between the comb fingers. In the three-layer comb finger structure the first fixed comb fingers and second fixed comb fingers are electrically isolated from each other by using the insulation layer 1303, and a support beam and a substrate are also electrically isolated from each other by using the insulation layer, so that one insulation layer implements two types of electrical isolation. 14. Prepare metal electrodes 1301 and a mirror reflection layer 1302.

Although the present invention is described with reference to the embodiments, in a process of implementing the present invention that claims protection, a person skilled in the art may understand and implement another variation of the disclosed embodiments by viewing the accompanying drawings, disclosed content, and the appended claims. In the claims, "including" (including) does not exclude another component or another step, and "a" or "one" does not exclude a meaning of plurality. Some measures are recorded in dependent claims that are different from each other, but this does not mean that these measures cannot be combined to produce a better effect.

Although the present invention is described with reference to specific features and embodiments thereof, it is obvious that various modifications and combinations may be made thereto. Correspondingly, the specification and the accompanying drawings are merely example description of the present invention defined by the appended claims, and are considered as any of or all modifications, variations, combinations or equivalents that cover the scope of the present invention. It is clear that a person skilled in the art can make various modifications and variations to the present invention without departing from the scope of the present invention. The present invention is intended to cover these modifications and variations provided that they fall within the scope of protection defined by the following claims.

## Claims

1. A micro-electro-mechanical systems, MEMS, apparatus, comprising first fixed comb fingers (301), second fixed comb fingers (302), a support beam (303), a movable platform (304), and movable comb fingers (305), wherein
the first fixed comb fingers (301) and the second fixed comb fingers (302) are fastened to a substrate, and the first fixed comb fingers (301) are electrically isolated from the second fixed comb fingers (302);
two ends of the support beam (303) are fastened to the substrate, and the movable platform (304) is connected to the support beam (303); and
the movable comb fingers (305) are connected to the movable platform (304), and form a three-layer comb finger structure with the first fixed comb fingers (301) and the second fixed comb fingers (302);
wherein the first fixed comb fingers (301) are arranged in a first layer, the second fixed comb fingers (302) are arranged in a second layer, and the movable comb fingers (305) are arranged in a third layer between the first and second layers;
wherein the first fixed comb fingers (301) are electrically isolated from the second fixed comb fingers (302) by using a first insulation layer (306), **characterized in that** the support beam (303) is electrically isolated from the substrate; and the support beam (303) is electrically isolated from the substrate by using a second insulatior layer (306), and the first insulation layer (306) and the second insulation layer (306) are located on a same plane.

2. The MEMS apparatus according to claim 1, wherein the MEMS apparatus comprises two three-layer comb finger structures, respectively located on a left side and a right side of the support beam.

3. The MEMS apparatus according to claim 1 or 2, wherein the first fixed comb fingers are configured to apply a first electric potential difference between the first fixed comb fingers and the movable comb fingers, and the second fixed comb fingers are configured to apply a second electric potential difference between the second fixed comb fingers and the movable comb fingers.

4. The MEMS apparatus according to any one of claims 1 to 3, wherein a metal reflection layer or a dielectric reflection layer is plated on the movable platform.

5. The MEMS apparatus according to any one of claims 1 to 4, wherein the first fixed comb fingers are configured to apply an electric potential difference between the first fixed comb fingers and the movable comb fingers, and the second fixed comb fingers are configured to measure a rotation angle of the movable platform by using a capacitance between the second fixed comb fingers and the movable comb fingers.

6. The MEMS apparatus according to any one of claims 1 to 5, wherein the movable comb fingers are connected to a side that is of the movable platform and that is perpendicular to the support beam.

7. The MEMS apparatus according to any one of claims 1 to 6, wherein the MEMS apparatus comprises two three-layer comb finger structures, located on a same side of the support beam, and the two three-layer comb finger structures are separately configured to control the movable platform.

8. The MEMS apparatus according to claim 7, wherein one of the two three-layer comb finger structures is configured to apply an electric potential difference to drive the movable platform, and the other three-layer comb finger structure is configured to measure a rotation angle of the movable platform.

9. A two-dimensional micro-electro-mechanical systems, MEMS, apparatus, comprising a first MEMS apparatus according to any one of claims 1 to 8 and a second MEMS apparatus according to any one of claims 1 to 8, wherein
a movable platform of the first MEMS apparatus is used as a substrate for fastening the second MEMS apparatus; and
a support beam of the first MEMS apparatus and a support beam of the second MEMS apparatus are perpendicular to each other.

10. A micro-electro-mechanical systems, MEMS, apparatus array, comprising a plurality of MEMS apparatuses according to any one of claims 1 to 9, wherein the plurality of MEMS apparatuses are one-dimensionally distributed or two-dimensionally distributed.

11. The MEMS apparatus according to any one of claims 1 to 9, further comprising the substrate, a tube housing, a light window, and a control circuit, wherein
the substrate is configured to: fasten the first fixed comb fingers and the second fixed comb fingers, and fasten the two ends of the support beam;
the tube housing is installed on the substrate, and is configured to protect the MEMS apparatus;
the light window is installed on the top of the tube housing, and is configured for light incidence and emergence; and
the control circuit is configured to control rotation of the movable platform.

12. A preparation method of the MEMS apparatus according to any one of claims 1 to 9, comprising:
forming the first fixed comb fingers on a first wafer through photoetching;
forming the movable comb fingers, the movable platform, and the support beam on a double-layer second wafer through photoetching;
bonding the first wafer to the double-layer second wafer;
forming the second fixed comb fingers on the bonded wafer through photoetching; and
releasing the movable platform and the movable comb fingers.

13. A preparation method of the MEMS apparatus according to any one of claims 1 to 9, comprising:
forming the first fixed comb fingers on a first wafer through photoetching;
bonding a second wafer to the first wafer;
forming, through photoetching, the movable comb fingers, the movable platform, and the support beam on the wafer obtained after the two wafers are bonded;
bonding a third wafer to the wafer obtained after the two wafers are bonded;
forming, through photoetching, the second fixed comb fingers on the wafer obtained after the three wafers are bonded; and
releasing the movable platform and the movable comb fingers.

## Patentansprüche

1. Einrichtung für mikroelektromechanische Systeme, MEMS, die erste feste Kammzinken (301), zweite feste Kammzinken (302), einen Stützbalken (303), eine bewegliche Plattform (304) und bewegliche Kammzinken (305) umfasst, wobei die ersten festen Kammzinken (301) und die zweiten festen Kammzinken (302) an einem Substrat befestigt sind, und die ersten festen Kammzinken (301) von den zweiten festen Kammzinken (302) elektrisch isoliert sind;
zwei Enden des Stützbalkens (303) an dem Substrat befestigt sind, und die bewegliche Plattform (304) mit dem Stützbalken (303) verbunden ist; und die beweglichen Kammzinken (305) mit der beweglichen Plattform (304) verbunden sind und mit den ersten festen Kammzinken (301) und den zweiten festen Kammzinken (302) eine dreischichtige Kammzinkenstruktur ausbilden;
wobei die ersten festen Kammzinken (301) in einer ersten Schicht angeordnet sind, die zweiten festen Kammzinken (302) in einer zweiten Schicht angeordnet sind und die beweglichen Kammzinken (305) in einer dritten Schicht zwischen der ersten und der zweiten Schicht angeordnet sind:
wobei die ersten festen Kammzinken (301) durch Verwenden einer ersten Isolierschicht (306) von den zweiten festen Kammzinken (302) elektrisch isoliert sind,
**dadurch gekennzeichnet, dass** der Stützbalken (303) von dem Substrat elektrisch isoliert ist; und
der Stützbalken (303) durch Verwenden einer zweiten Isolierschicht (306) von dem Substrat elektrisch isoliert ist, und die erste Isolierschicht (306) und die zweite Isolierschicht (306) sich auf einer gleichen Ebene befinden.

2. MEMS-Einrichtung nach Anspruch 1, wobei die MEMS-Einrichtung zwei dreischichtige Kammzinkenstrukturen, die jeweils auf einer linken Seite und einer rechten Seite des Stützbalkens angeordnet sind, umfasst.

3. MEMS-Einrichtung nach Anspruch 1 oder 2, wobei die ersten festen Kammzinken konfiguriert sind, um eine erste elektrische Potenzialdifferenz zwischen den ersten festen Kammzinken und den beweglichen Kammzinken anzulegen, und die zweiten festen Kammzinken konfiguriert sind, um eine zweite elektrische Potenzialdifferenz zwischen den zweiten festen Kammzinken und den beweglichen Kammzinken anzulegen.

4. MEMS-Einrichtung nach einem der Ansprüche 1 bis 3, wobei eine Metallreflexionsschicht oder eine dielektrische Reflexionsschicht auf der beweglichen Plattform plattiert ist.

5. MEMS-Einrichtung nach einem der Ansprüche 1 bis 4, wobei die ersten festen Kammzinken konfiguriert sind, um eine elektrische Potenzialdifferenz zwischen den ersten festen Kammzinken und den beweglichen Kammzinken anzulegen, und die zweiten festen Kammzinken konfiguriert sind, um einen Drehwinkel der beweglichen Plattform durch Verwenden einer Kapazität zwischen den zweiten feststehenden Kammzinken und den beweglichen Kammzinken zu messen.

6. MEMS-Einrichtung nach einem der Ansprüche 1 bis 5, wobei die beweglichen Kammzinken mit einer Seite der beweglichen Plattform verbunden sind, die senkrecht zu dem Stützbalken ist.

7. MEMS-Einrichtung nach einem der Ansprüche 1 bis 6, wobei die MEMS-Einrichtung zwei dreischichtige Kammzinkenstrukturen umfasst, die auf einer gleichen Seite des Stützbalkens angeordnet sind, und die zwei dreischichtigen Kammzinkenstrukturen separat konfiguriert sind, um die bewegliche Plattform zu steuern.

8. MEMS-Einrichtung nach Anspruch 7, wobei eine der zwei dreischichtigen Kammzinkenstrukturen konfiguriert ist, um eine elektrische Potenzialdifferenz anzulegen, um die bewegliche Plattform anzutreiben, und die andere dreischichtige Kammzinkenstruktur konfiguriert ist, um einen Drehwinkel der beweglichen Plattform zu messen.

9. Einrichtung für zweidimensionale mikroelektromechanische Systeme, MEMS, die eine erste MEMS-Einrichtung nach einem der Ansprüche 1 bis 8 und eine zweite MEMS-Einrichtung nach einem der Ansprüche 1 bis 8 umfasst, wobei
eine bewegliche Plattform der ersten MEMS-Einrichtung als ein Substrat zum Befestigen der zweiten MEMS-Einrichtung verwendet wird; und
ein Stützbalken der ersten MEMS-Einrichtung und ein Stützbalken der zweiten MEMS-Einrichtung senkrecht zueinander stehen.

10. Einrichtungsarray für mikroelektromechanische Systeme, MEMS, das eine Vielzahl von MEMS-einrichtungen nach einem der Ansprüche 1 bis 9 umfasst, wobei die Vielzahl von MEMS-Einrichtungen eindimensional verteilt oder zweidimensional verteilt ist.

11. MEMS-Einrichtung nach einem der Ansprüche 1 bis 9, die ferner das Substrat, ein Röhrengehäuse, ein Lichtfenster und eine Steuerschaltung umfasst, wobei das Substrat konfiguriert ist zum: Befestigen der ersten festen Kammzinken und der zweiten festen Kammzinken und Befestigen der zwei Enden des Stützbalkens; das Röhrengehäuse auf dem Substrat installiert ist und konfiguriert ist, um die MEMS-Einrichtung zu schützen;
das Lichtfenster auf der Oberseite des Röhrengehäuses installiert ist und für einen Lichteinfall und Lichtaustritt konfiguriert ist; und
die Steuerschaltung konfiguriert ist, um die Drehung der beweglichen Plattform zu steuern.

12. Herstellungsverfahren der MEMS-Einrichtung nach einem der Ansprüche 1 bis 9, das umfasst:
Ausbilden der ersten festen Kammzinken auf einem ersten Wafer durch Fotoätzen;
Ausbilden der beweglichen Kammzinken, der beweglichen Plattform und des Stützbalkens auf einem doppelschichtigen zweiten Wafer durch Fotoätzen;
Bonden des ersten Wafers mit dem doppelschichtigen zweiten Wafer;
Ausbilden der zweiten festen Kammzinken auf dem gebondeten Wafer durch Fotoätzen; und
Freigeben der beweglichen Plattform und der beweglichen Kammzinken.

13. Herstellungsverfahren der MEMS-Einrichtung nach einem der Ansprüche 1 bis 9, das umfasst:
Ausbilden der ersten festen Kammzinken auf einem ersten Wafer durch Fotoätzen;
Bonden eines zweiten Wafers an den ersten Wafer;
Ausbilden, durch Fotoätzen, der beweglichen Kammzinken, der beweglichen Plattform und des Stützbalkens auf dem Wafer, der nach dem Bonden der zwei Wafer erhalten wird;
Bonden eines dritten Wafers an den Wafer, der nach dem Bonden der zwei Wafer erhalten wird;
Ausbilden, durch Fotoätzen, der zweiten festen Kammzinken auf dem Wafer, der nach dem Bonden der drei Wafer erhalten wird; und
Freigeben der beweglichen Plattform und der beweglichen Kammzinken.

## Revendications

1. Appareil de systèmes microélectromécaniques, MEMS, comprenant des premiers doigts de peigne fixes (301), des seconds doigts de peigne fixes (302), une poutre de support (303), une plate-forme mobile (304) et des doigts de peigne mobiles (305), dans lequel
les premiers doigts de peigne fixes (301) et les seconds doigts de peigne fixes (302) sont fixés à un substrat, et les premiers doigts de peigne fixes (301) sont isolés électriquement des seconds doigts de peigne fixes (302) ;
deux extrémités de la poutre de support (303) sont fixées au substrat, et la plate-forme mobile (304) est reliée à la poutre de support (303) ; et
les doigts de peigne mobiles (305) sont reliés à la plate-forme mobile (304), et forment une structure à trois couches de doigts de peigne avec les premiers doigts de peigne fixes (301) et les seconds doigts de peigne fixes (302) ;
dans lequel les premiers doigts de peigne fixes (301) sont agencés dans une première couche, les seconds doigts de peigne fixes (302) sont agencés dans une deuxième couche, et les doigts de peigne mobiles (305) sont agencés dans une troisième couche entre les première et deuxième couches :
dans lequel les premiers doigts de peigne fixes (301) sont isolés électriquement des seconds doigts de peigne fixes (302) en utilisant une première couche d'isolation (306), **caractérisé en ce que** la poutre de support (303) est électriquement isolée du substrat ; et
la poutre de support (303) est électriquement isolée du substrat en utilisant une seconde couche isolante (306), et la première couche isolante (306) et la seconde couche isolante (306) sont situées sur un même plan.

2. Appareil MEMS selon la revendication 1, dans lequel l'appareil MEMS comprend deux structures de doigt de peigne à trois couches, respectivement situées sur un côté gauche et un côté droit de la poutre de support.

3. Appareil MEMS selon la revendication 1 ou 2, dans lequel les premiers doigts de peigne fixes sont configurés pour appliquer une première différence de potentiel électrique entre les premiers doigts de peigne fixes et les doigts de peigne mobiles, et les seconds doigts de peigne fixes sont configurés pour appliquer une seconde différence de potentiel électrique entre les seconds doigts de peigne fixes et les doigts de peigne mobiles.

4. Appareil MEMS selon l'une quelconque des revendications 1 à 3, dans lequel une couche de réflexion métallique ou une couche de réflexion diélectrique est plaquée sur la plate-forme mobile.

5. Appareil MEMS selon l'une quelconque des revendications 1 à 4, dans lequel les premiers doigts de peigne fixes sont configurés pour appliquer une différence de potentiel électrique entre les premiers doigts de peigne fixes et les doigts de peigne mobiles, et les seconds doigts de peigne fixes sont configurés pour mesurer un angle de rotation de la plate-forme mobile en utilisant une capacité entre les seconds doigts de peigne fixes et les doigts de peigne mobiles.

6. Appareil MEMS selon l'une quelconque des revendications 1 à 5, dans lequel les doigts de peigne mobiles sont reliés à un côté qui appartient à la plate-forme mobile et qui est perpendiculaire à la poutre de support.

7. Appareil MEMS selon l'une quelconque des revendications 1 à 6, dans lequel l'appareil MEMS comprend deux structures de doigts en peigne à trois couches, situées sur un même côté de la poutre de support, et les deux structures à doigts de peigne à trois couches sont configurées séparément pour commander la plate-forme mobile.

8. Appareil MEMS selon la revendication 7, dans lequel l'une des deux structures de doigts de peigne à trois couches est configurée pour appliquer une différence de potentiel électrique afin d'entraîner la plate-forme mobile, et l'autre structure de doigts de peigne à trois couches est configurée pour mesurer un angle de rotation de la plate-forme mobile.

9. Appareil de systèmes microélectromécaniques, MEMS, bidimensionnel, comprenant un premier appareil MEMS selon l'une quelconque des revendications 1 à 8 et un second appareil MEMS selon l'une quelconque des revendications 1 à 8, dans lequel une plate-forme mobile du premier appareil MEMS est utilisée en tant que substrat pour fixer le second appareil MEMS ; et
une poutre de support du premier appareil MEMS et une poutre de support du second appareil MEMS sont perpendiculaires l'une à l'autre.

10. Réseau d'appareils de systèmes microélectromécaniques, MEMS, comprenant une pluralité d'appareils MEMS selon l'une quelconque des revendications 1 à 9, dans lequel la pluralité d'appareils MEMS sont répartis de manière unidimensionnelle ou bidimensionnelle.

11. Appareil MEMS selon l'une quelconque des revendications 1 à 9, comprenant en outre le substrat, un logement de tube, une fenêtre optique et un circuit de commande, dans lequel le substrat est conçu pour : fixer les premiers doigts de peigne fixes et les seconds doigts de peigne fixes, et fixer les deux extrémités de la poutre de support ;
le logement de tube est installé sur le substrat, et est conçu pour protéger l'appareil MEMS ;
la fenêtre optique est installée sur le dessus du logement de tube et est conçue pour l'incidence et l'émergence de la lumière ; et
le circuit de commande est configuré pour commander la rotation de la plate-forme mobile.

12. Procédé de préparation de l'appareil MEMS selon l'une quelconque des revendications 1 à 9, comprenant :
la formation des premiers doigts de peigne fixes sur une première plaquette par photogravure ;
la formation des doigts de peigne mobiles, de la plate-forme mobile et de la poutre de support sur une seconde plaquette à double couche par photogravure ;
la liaison de la première plaquette à la seconde plaquette à double couche ;
la formation des seconds doigts de peigne fixes sur la plaquette liée par photogravure ; et
la libération de la plate-forme mobile et des doigts de peigne mobiles.

13. Procédé de préparation de l'appareil MEMS selon l'une quelconque des revendications 1 à 9, comprenant :
la formation des premiers doigts de peigne fixes sur une première plaquette par photogravure ;
la liaison d'une deuxième plaquette à la première plaquette ;
la formation, par photogravure, des doigts de peigne mobiles, de la plate-forme mobile et de la poutre de support sur la plaquette obtenue après liaison des deux plaquettes ;
la liaison d'une troisième plaquette à la plaquette obtenue après liaison des deux plaquettes ;
la formation, par photogravure, des seconds doigts de peigne fixes sur la plaquette obtenue après liaison des trois plaquettes ; et
la libération de la plate-forme mobile et des doigts de peigne mobiles.
